# EUROPEAN PATENT SPECIFICATION

(11) **EP 1 391 533 B1**
(45) Date of publication and mention of the grant of the patent: **12.09.2007**
(21) Application number: 03254804.2
(22) Date of filing: 31.07.2003
(51) Int. Cl.: C23C 14/14, C23C 14/16, C22C 21/00

(54) **Method for protecting articles, and related compositions**
Verfahren zum Schutz von Artikeln, und entsprechende Zusammensetzungen
Méthode pour protéger des articles, et compositions associées

(30) Priority: 31.07.2002 US 64618
(43) Date of publication of application: 25.02.2004
(73) Proprietor: GENERAL ELECTRIC COMPANY, Schenectady, NY 12345 (US)
(72) Inventor: Lipkin, Don Mark, Niskayuna New York 12309 (US); Zhao, Ji-Cheng, Latham New York 12110 (US)
(74) Representative: Pedder, James Cuthbert

(56) References cited:
- EP-A- 0 560 045
- EP-A- 1 184 475
- EP-A- 1 347 079
- US-A- 3 341 307
- US-B1- 6 287 644
- PATENT ABSTRACTS OF JAPAN vol. 1996, no. 11, 29 November 1996 (1996-11-29) -& JP 08 176762 A (YAMAHA CORP), 9 July 1996 (1996-07-09)

## Description

This invention relates to oxidation resistant coatings. More particularly, this invention relates to methods of protecting articles from high temperature, oxidative environments using ion plasma deposited coatings. This invention also relates to material compositions suitable for use in the ion deposition process.

US-B-6 287 644 relates to a method for forming a bond coat on articles exposed to high temperatures, like turbine engine components. Ion plasma deposition (IPD) is used to deposit an Al-Cu layer thereon.

Nickel (Ni), cobalt (Co), and iron (Fe) based alloys are frequently used to form articles designed for use in high temperature, highly oxidative environments. Such articles include components that are used in turbine systems, such as, but not limited to, aircraft turbines, land-based turbines, marine-based turbines, and the like. To survive in such environments, articles made of these alloys often require coatings, herein referred to as "high-temperature coatings," to protect the underlying alloys against oxidation and hot corrosion. In some cases, the high-temperature coatings may also serve as bond coating to retain a thermal barrier coating. The high-temperature coating is often a nickel aluminide (NiAI)-based material, sometimes modified by additions of platinum (Pt) to form a platinum nickel aluminide-based coating. In other cases, the high-temperature coating is an alloy comprising chromium (Cr), aluminum (Al), and at least one of iron (Fe), nickel (Ni), and cobalt (Co); these coatings are often referred to in the art as "MCrAIX coatings," where M represents a material comprising at least one of Fe, Ni, and Co, and X represents additional reactive elements as described below.

Addition of reactive elements such as zirconium, hafnium, silicon, titanium, lanthanum, cerium, yttrium, and the like, have been found to be effective in improving the performance of nickel aluminide-based and MCrAIX-based coatings. However, adding the reactive elements to the coatings in a manner that is cost-effective and consistent has proven to be a significant technical challenge. For example, although electron beam physical vapor deposition (EBPVD) has been used to deposit NiAI-based and MCrAIX-based coatings, maintaining compositional control of the reactive elements has proven to be difficult, leading to unacceptable variability in coating performance. Chemical vapor deposition (CVD) techniques also suffer from problems with compositional inconsistency, which increase as the compositional complexity of the desired coating alloy increases.

The ion plasma deposition (IPD) process provides an attractive alternative to CVD and EB-PVD for high-temperature coating deposition, offering advantages in both compositional control and lower production equipment cost over the former. However, the NiAI-based target materials from which the deposit is made are very brittle, limiting the application of IPD in production environments.

Therefore, there is a need to provide high temperature coatings with improved performance, consistency, and cost-effectiveness. There is also a need for materials suitable for use as targets in the IPD coating process that provide more reliable, cost-effective performance.

Embodiments of the present invention are provided to address these and other needs. One embodiment is a method for protecting an article from a high temperature, oxidative environment. The method comprises providing a substrate, providing an ion plasma deposition target, and depositing a protective coating onto the substrate using the target in an ion plasma deposition process. The target comprises to:
from about 2 atom percent to about 25 atom percent chromium,
up to about 4 atom percent of a material selected from the group consisting of zirconium, hafnium, tantalum, silicon, yttrium, titanium, lanthanum, cerium, and combinations thereof;
up to about 0.2 percent of a material selected from the group consisting of carbon, boron, and combinations thereof; and
the balance aluminum.

Another embodiment is a target for use in an ion plasma deposition process, comprising the alloy of the present invention.

Another embodiment is an article for use in a high temperature, oxidative environment. The article comprises a substrate and a coating disposed on the substrate, and the coating comprises the article of the present invention.

The invention will now be described in greater detail, by way of example, with reference to the drawing, the single figure of which :is a schematic of an ion plasma deposition apparatus.

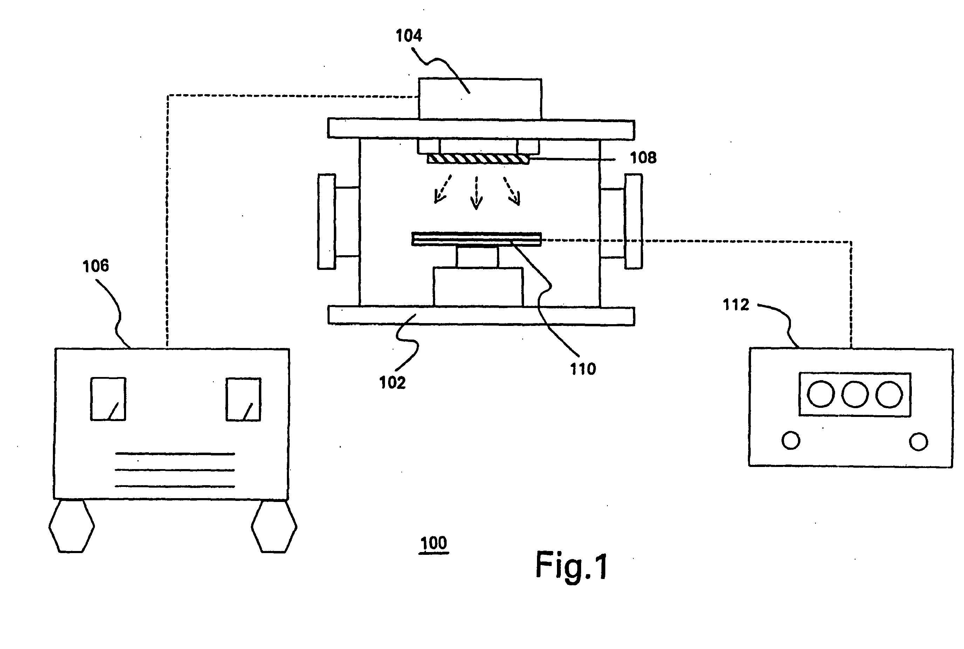

Ion Plasma Deposition (IPD) is a physical vapor deposition process that has been used in such industrial applications as wear-resistant coatings, decorative coatings, and high-temperature protective coatings. Referring to Figure 1, an exemplary IPD coating apparatus 100 in part comprises a vacuum chamber 102 upon which is mounted a cathodic arc source 104. Cathodic arc source 104 is coupled to a first DC power supply 106 and in part comprises a target 108, which is made of the material to be deposited. During the IPD process, an electric arc sweeping across the cathodic arc source 104 evaporates material at the surface of the target 108, and the evaporated material is then deposited on the substrate 110. In an arc discharge, the cathodic current is concentrated at minute, extremely energetic cathode arc spots, producing an electron current in a plasma of highly ionized metal vapor. Because of the high energy of the arc process, all alloying elements of a target material are uniformly ejected, promoting consistent and predictable compositional transfer of material from target 108 to substrate 110. The process is carried out in a typical vacuum of 10⁻³ to 10⁻⁶ Torr. No crucible material is needed to contain molten material, in contrast to other PVD methods. Consequently, IPD advantageously produces dense, multicomponent coatings of high purity.

Embodiments of the present invention include a method for protecting an article from a high temperature, oxidative environment, using a coating process based on the IPD method. In these embodiments, a substrate 110 is provided. The term "substrate" as used herein means any article upon which a coating is subsequently disposed. Substrate 110 comprises at least one of a nickel alloy, an iron alloy, and a cobalt alloy in some embodiments, including, for example, the class of high strength, high temperature alloys well-known in the art as "superalloys." In particular embodiments, providing a superalloy substrate comprises providing a component for service in a hot gas path of a gas turbine assembly. Examples of such components include, but are not limited to, turbine blades, vanes, and combustion components such as liners and transition pieces. The method of the present invention is suitable for use as a method for protecting a new article and as a method for protecting an article that has been previously used. For example, the method of the present invention is suitable for use in a repair process for articles that have been used previously in a high temperature, oxidative environment, such as a gas turbine assembly. Accordingly, in certain embodiments of the present invention, the provided substrate 110 comprises at least one coating. Depending on the composition and condition of the coating on substrate 110, the coating may be removed prior to being provided for the method of the present invention, or the substrate may be provided with the coating attached.

An IPD target 108 is provided. Target 108 comprises from about 2 atom percent to about 25 atom percent chromium, and the balance aluminum. Using such an alloy composition for target 108 provides several advantages over other methods for manufacturing NiAI-based coatings. The material used for target 108 in embodiments of the present invention is significantly less expensive and more easily machined than the commonly used NiAI-based materials. Furthermore, the excellent compositional transfer characteristics of the IPD method used in the present invention allow the well-controlled incorporation of reactive elements into the coating process. Accordingly, the target 108 further comprises up to about 4 atom percent of a material selected from the group consisting of zirconium, hafnium, tantalum, silicon, yttrium, titanium, lanthanum, cerium, and combinations thereof; and up to about 0.2 percent of a material selected from the group consisting of carbon, boron, and combinations thereof. In particular embodiments, target 108 comprises about 9 atom percent chromium, about 1 atom percent zirconium, and the balance aluminum. In alternative embodiments, target 108 comprises about 9 atom percent chromium, about 1 atom percent zirconium, about 2 atom percent tantalum, and the balance aluminum. In further alternative embodiments, target 108 comprises about 9 atom percent chromium, about 1.5 atom percent hafnium, about 1.5 atom percent silicon, and the balance aluminum. Those skilled in the art will recognize that a particular choice of alloy composition for target 108 depends upon several factors, including the choice of substrate 110 material and the type of environmental exposure expected to be endured by the protected article.

In a typical commercially available IPD coating apparatus, target 108 is in the form of a simple shape, such as, but not limited to, a cylinder. The materials described above as suitable target 108 materials are manufactured by materials processing methods common in the art. Those skilled in the art will understand that commonly used metallurgical and manufacturing processes are suitable for the manufacture of the alloys, and in the formation of the alloys into IPD targets for use in embodiments of the present invention. Accordingly, in some embodiments, providing the ion plasma deposition target 108 comprises providing a target 108 manufactured using at least one of casting and powder metallurgy processing.

A protective coating is deposited onto substrate 110 using target 108 in an IPD process as described above. In some embodiments, a negative potential bias is applied to substrate 110, for example by a second DC power supply 112 coupled to substrate 110. Applying the negative potential bias results in an increase in substrate heating during IPD coating, and this heating causes interdiffusion and reaction among the elements of the deposited material and the material of substrate 110 to form, in situ, advantageous coating compositions. For example, in embodiments in which substrate 110 comprises a nickel-based superalloy, biasing the substrate 110 during IPD coating of the aluminum-rich alloy from the target 108 causes an interaction to occur between the two materials, transforming the protective coating from an aluminum alloy coating (of composition similar to, or identical with, the composition of target 108) to one comprising NiAI-based material. In certain embodiments, applying the negative potential bias comprises applying a potential bias in the range from about -10 volts to about -1000 volts, for example, a potential bias in the range from about -50 volts to about -250 volts. The particular value chosen for the potential bias depends on, for instance, the amount and type of interaction desired to occur between the deposited material and the substrate 110 material. In alternative embodiments, depositing the protective coating onto the substrate further comprises grounding the substrate, which heats the substrate in a similar manner to applying a bias and causes an interaction as described above.

The thickness of the protective coating is generally determined by factors such as, for example, the time and temperature of exposure expected for the substrate 110 being protected. In some embodiments, the protective coating is deposited to have a thickness in the range of from about 5 micrometers to about 250 micrometers. In particular embodiments, the coating thickness is in the range from about 25 micrometers to about 75 micrometers. Moreover, a protective coating made by the method of the present invention is suitable for use as a bondcoat in a thermal barrier coating system. Accordingly, in certain embodiments of the present invention, the method further comprises coating said protective layer with a thermal barrier coating such as, for example, a thermal barrier coating comprising yttria-stabilized zirconia. Application of the thermal barrier coating is accomplished via any of several suitable processes, including, but not limited to, plasma spraying and physical vapor deposition.

Embodiments of the present invention include variations on the method described above. The method of the present invention further comprises coating substrate 110 with a metal layer prior to depositing the protective coating. Any of several coating methods is suitable to coat substrate 110 with this metal layer, including, but not limited to, electroplating, electroless plating, chemical vapor deposition, and physical vapor deposition. The metal layer is deposited at a thickness in the range from about 2 micrometers to about 25 micrometers in some embodiments, and in particular embodiments, the thickness of the metal layer is in the range from about 2 micrometers to about 6 micrometers. The metal layer comprises at least one of platinum, palladium, nickel, and cobalt. The use of nickel or cobalt in the metal layer makes these materials available for subsequent reaction with the protective coating to form desirable high-temperature phases such as nickel aluminide. Coating substrate 110 with a metal layer comprising at least one of platinum and palladium prior to depositing the protective coating gives the method the potential to form, for example, platinum modified nickel aluminide-based protective coatings. The substrate 110 is then heat treated after coating substrate 110 with the metal layer, for example at a temperature in the range from about 700°C to about 1200°C for a time in the range from about 30 minutes to about 8 hours. This heat treatment step allows interdiffusion of the metal layer material and the substrate material, such as, for instance, creating a Pt-enriched Ni-bearing layer at the surface of substrate 110.

Subsequent deposition of the Al-rich alloy in accordance with the method of the present invention, along with interaction of the Al-rich material with, for example, the Pt-enriched Ni-bearing substrate 110 as described above, can create a platinum modified nickel aluminide-based protective coating. The interaction can be created in situ during the IPD coating step by applying a bias to, or by grounding, substrate 110 as described previously. Furthermore, the method of the present invention, in some embodiments, further comprises heat treatment of the substrate after depositing the protective coating. The heat treatment times and temperatures described above for heat treating the metal layer are suitable for heat treating the protective coating as well. This heat treatment may be used in conjunction with biasing or grounding substrate 110 to further augment the interaction between coating and substrate materials, or the heat treatment of the substrate after depositing the protective coating may be used to cause the entirety of the interaction, in embodiments where a substantial interaction is not generated during IPD coating.

The use of heat treatment, substrate bias, substrate grounding, and combinations thereof, as described above, is generally directed towards the creation of a protective coating on the surface of substrate 110 by causing elements from the substrate to interact with the aluminum-rich alloy deposited during the IPD process to form various protective materials. The example of coating a Ni-based substrate to form an alloyed NiAI-based protective coating has been described above. Advantageously, the method of the present invention allows the formation of such a coating without the need for a NiAI-based target 108, which would be significantly more complex to manufacture and more brittle than the target 108 according to embodiments of the present invention.

Those skilled in the art will appreciate that, through selection of the composition of substrate 110, target 108, heat treatment, and, in some embodiments, the metal layer, the method of the present invention may be used to control the composition of the protective coating. In some embodiments, depositing the protective coating comprises forming a protective coating comprising at least 80 volume percent of a single phase, such as, for example, a B2-structured aluminide intermetallic phase commonly observed in NiAl-based high temperature coatings. In other embodiments, depositing said protective coating comprises forming a protective coating comprising at least two phases, such as, for example, the aforementioned B2-structured phase and a platinum aluminide, PtAl₂, which is commonly observed in platinum modified nickel aluminide-based high temperature coatings. Thus, the method of the present invention may be used in certain embodiments to create coatings with structures, compositions, and properties commonly used in industry as protective, high temperature coatings.

In order to take further advantage of the benefits of embodiments described above, an object of the present invention is a method for protecting an article from a high temperature, oxidative environment, the method comprising:
providing a substrate 110 comprising a nickel-based superalloy;
providing an ion plasma deposition target 108, the target 108 comprising
from about 2 atom percent to about 25 atom percent chromium,
up to about 4 atom percent of a material selected from the group consisting of zirconium, hafnium, tantalum, silicon, yttrium, titanium, lanthanum, cerium, and combinations thereof,
up to about 0.2 percent of a material selected from the group consisting of carbon, boron, and combinations thereof, and
the balance aluminum;
depositing a protective coating onto the substrate 110 using the target 108 in an ion plasma deposition process, wherein a negative potential bias is applied to the substrate 110 during deposition of the protective coating; and
heat treating the substrate 110 after depositing the protective coating;
wherein after heat treating, the protective coating comprises a B2-structured aluminide intermetallic phase. The additional steps of coating substrate 110 with a metal layer comprising at least one of platinum, palladium, nickel, and cobalt, and heat treating substrate 110 after coating substrate 110 with the metal layer, described previously, belong to this embodiment as well.

As described above, the method of the present invention advantageously allows the use of relatively inexpensive, easily machined aluminum-rich alloys to form, for example, aluminide-based protective coatings. Accordingly, embodiments of the present invention further include an alloy suitable for use in the method of the present invention. This alloy has been described above in the discussion pertaining to the step of providing an IPD target 108, along with multiple examples of particular alloys within the described composition range. Embodiments of the present invention also include a target for use in an ion plasma deposition process, comprising the alloy of the present invention as described above; and further embodiments include an article for use in a high temperature, oxidative environment, wherein the article comprises a substrate and a coating disposed on the substrate, and the coating comprises the alloy of the present invention as described above.

Various aspects of the invention are set out in the following:
A method for protecting an article from a high temperature, oxidative environment, said method comprising:
   providing a substrate (110);
   providing an ion plasma deposition target (108), said target (108) comprising
   from about 2 atom percent to about 25 atom percent chromium, and
   the balance aluminum; and
   depositing a protective coating onto said substrate (110) using said target (108) in an ion plasma deposition process.
Providing said target (108) comprises providing a target (108) further comprising at least one of zirconium, hafnium, tantalum, silicon, yttrium, titanium, lanthanum, cerium, carbon, and boron.
Providing said target (108) comprises providing a target (108) further comprising up to about 4 atom percent of a material selected from the group consisting of zirconium, hafnium, tantalum, silicon, yttrium, titanium, lanthanum, cerium, and combinations thereof; and up to about 0.2 percent of a material selected from the group consisting of carbon, boron, and combinations thereof.
Providing said target (108) comprises providing a target (108) comprising
   about 9 atom percent chromium,
   about 1 atom percent zirconium, and
   the balance comprising aluminum.
Providing said target (108) comprises providing a target (108) comprising
   about 9 atom percent chromium,
   about 1 atom percent zirconium,
   about 2 atom percent tantalum, and
   the balance comprising aluminum.
Providing said target (108) comprises providing a target (108) comprising
   about 9 atom percent chromium,
   about 1.5 atom percent hafnium,
   about 1.5 atom percent silicon, and
   the balance comprising aluminum.
Coating said substrate (110) with a metal layer prior to depositing said protective coating.
Coating said substrate (110) with a metal layer comprises coating said substrate (110) with a metal layer comprising at least one of platinum, palladium, nickel, and cobalt.
The heat treating of said substrate (110) after coating said substrate (110) with said metal layer.
The heat treating comprises heating said substrate (110) to a temperature in the range from about 900°C to about 1200°C for a time in the range from about 30 minutes to about 8 hours.
The coating of said substrate (110) with a metal layer comprises coating with a layer having a thickness in the range from about 2 micrometers to about 25 micrometers.
The coating of said substrate (110) with a metal layer comprises coating with a layer having a thickness in the range from about 2 micrometers to about 6 micrometers.
Heat treating said substrate (110) after depositing said protective coating.
Heat treating comprises heating said substrate (110) to a temperature in the range from about 900°C to about 1200°C for a time in the range from about 30 minutes to about 8 hours.
The providing of said substrate (110) comprises providing at least one of a nickel alloy, an iron alloy, and a cobalt alloy.
The providing of said substrate (110) comprises providing a superalloy.
Providing said superalloy comprises providing a component for service in a hot gas path of a gas turbine assembly.
Providing a substrate (110) comprises providing a substrate (110) comprising at least one coating.
The providing of said ion plasma deposition target (108) comprises providing a target (108) manufactured using at least one of casting and powder metallurgy processing.
The depositing of said protective coating onto said substrate (110) further comprises applying a negative potential bias to said substrate (110).
Applying said negative potential bias comprises applying a potential bias in the range from about -10 volts to about -1000 volts.
Applying said negative potential bias comprises applying a potential bias in the range from about -50 volts to about -250 volts.
Depositing said protective coating onto said substrate (110) further comprises grounding said substrate (110).
Depositing said protective coating comprises depositing a protective coating having a thickness in the range from about 5 micrometers to about 250 micrometers.
Depositing said protective coating comprises depositing a protective coating having a thickness in the range from about 25 micrometers to about 75 micrometers.
Coating said protective layer with a thermal barrier coating.
The coating said protective layer with a thermal barrier coating comprises coating said protective layer with a thermal barrier coating comprising yttria-stabilized zirconia.
Depositing said protective coating comprises forming a protective coating comprising at least 80 volume percent of a single phase.
Depositing said protective coating comprises forming a protective coating comprising at least 80 volume percent of a B2-structured aluminide intermetallic phase.
Depositing said protective coating comprises forming a protective coating comprising at least two phases.
Depositing said protective coating comprises forming a protective coating comprising a B2-structured aluminide intermetallic phase and platinum aluminide (PtAl₂).
A method for protecting an article from a high temperature, oxidative environment, said method comprising:
   providing a substrate (110) comprising a nickel-based superalloy;
   providing an ion plasma deposition target (108), said target (108) comprising
   from about 2 atom percent to about 25 atom percent chromium,
   up to about 4 atom percent of a material selected from the group consisting of zirconium, hafnium, tantalum, silicon, yttrium, titanium, lanthanum, cerium, and combinations thereof,
   up to about 0.2 percent of a material selected from the group consisting of carbon, boron, and combinations thereof, and
   the balance aluminum;
   depositing a protective coating onto said substrate (110) using said target (108) in an ion plasma deposition process, wherein a negative potential bias is applied to said substrate (110) during deposition of said protective coating; and
   heat treating said substrate (110) after depositing said protective coating;
   wherein after heat treating, said protective coating comprises a B2-structured aluminide intermetallic phase.
The method mentioned above further comprises:
   coating said substrate (110) with a metal layer comprising at least one of platinum, palladium, nickel, and cobalt; and
   heat treating said substrate (110) after coating said substrate (110) with said metal layer.
An alloy comprising:
   from about 2 atom percent to about 25 atom percent chromium;
   up to about 4 atom percent of a material selected from the group consisting of zirconium, hafnium, tantalum, silicon, yttrium, titanium, lanthanum, cerium, and combinations thereof;
   up to about 0.2 percent of a material selected from the group consisting of carbon, boron, and combinations thereof; and
   the balance aluminum.
The alloy comprising:
   about 9 atom percent chromium;
   about 1 atom percent zirconium; and
   the balance aluminum.
The alloy comprising:
   about 9 atom percent chromium;
   about 1 atom percent zirconium;
   about 2 atom percent tantalum; and
   the balance aluminum.
The alloy comprising:
   about 9 atom percent chromium;
   about 1.5 atom percent hafnium;
   about 1.5 atom percent silicon; and
   the balance aluminum.
A target (108) for use in an ion plasma deposition process, said target (108) comprising:
   an alloy comprising
   from about 2 atom percent to about 25 atom percent chromium,
   up to about 4 atom percent of a material selected from the group consisting of zirconium, hafnium, tantalum, silicon, yttrium, titanium, lanthanum, cerium, and combinations thereof,
   up to about 0.2 percent of a material selected from the group consisting of carbon, boron, and combinations thereof, and the balance aluminum.
An article for use in a high temperature, oxidative environment, comprising:
   a substrate (110); and
   a coating disposed over said substrate, said coating comprising
   from about 2 atom percent to about 25 atom percent chromium,
   up to about 4 atom percent of a material selected from the group consisting of zirconium, hafnium, tantalum, silicon, yttrium, titanium, lanthanum, cerium, and combinations thereof,
   up to about 0.2 percent of a material selected from the group consisting of carbon, boron, and combinations thereof, and
   the balance aluminum.

## Claims

1. A method for protecting an article from a high temperature, oxidative environment, said method comprising:
providing a substrate (110);
providing an ion plasma deposition target (108), said target (908) consisting of from 2 atom percent to 25 atom percent chromium, and the balance being aluminum, and optionally up to about 4 atom percent of a material selected from the group consisting of zirconium, hafnium, tantalum, silicon, yttrium, titanium, lanthanum; cerium, and combinations thereof; and up to about 0.2 percent of a material selected from the group consisting of carbon, boron, and combinations thereof.;
depositing a protective coating onto said substrate (110) using said target (108) in an ion plasma deposition process;
coating the surface of the substrate (110) with a metal layer prior to depositing the protective coating, wherein the metal layer comprises at least one of platinum, palladium, nickel and cobalt; and
heat treating the substrate (110) after coating with the metal layer prior to ion plasma depositing the protective coating onto said substrate to interfuse the metal layer material and the substrate material.

2. The method of claim 1, wherein providing said target (108) comprises providing a target (108) comprising
9 atom percent chromium,
1 atom percent zirconium, and
the balance being aluminum.

3. The method of claim 1, wherein
the substrate (110) comprises a nickel-based superalloy;
wherein in the ion plasma deposition process, a negative potential bias is applied to said substrate (110) during deposition of said protective coating;
wherein said substrate (110) is heat treated after depositing said protective coating; and wherein
after heat treating, said protective coating comprises a B2-structured aluminide intermetallic phase;

4. An alloy comprising 9 atom percent chromium; and 1 atom percent zirconium, the balance being aluminum.

5. A target (108) for use in an ion plasma deposition process, said target (108) comprising the alloy of claim 4.

6. An article for use in a high temperature, oxidative environment, comprising:
a substrate (110); and
a coating disposed over said substrate, said coating comprising 9 atom percent chromium, 1 atom percent zirconium, and the balance being aluminum.

## Patentansprüche

1. Verfahren zum Schützen eines Gegenstandes vor einer oxidativen Umgebung hoher Temperatur, wobei das Verfahren umfasst:
Bereitstellen eines Substrates (110);
Bereitstellen eines Ionenplasma-Abscheidungstargets (108), wobei das Target (108) aus von 2 Atom-% bis 25 Atom-% Chrom, Rest Aluminium und, gegebenenfalls, bis zu etwa 4 Atom-% eines Materials, ausgewählt aus der Gruppe bestehend aus Zirkonium, Hafnium, Tantal, Silicium, Yttrium, Titan, Lanthan, Cer und Kombinationen davon und bis zu etwa 0,2 % eines Materials, ausgewählt aus der Gruppe bestehend aus Kohlenstoff, Bor und Kombinationen davon, besteht;
Abscheiden eines Schutzüberzuges auf dem Substrat (110) unter Einsatz des genannten Targets (108) in einem Ionenplasma-Abscheidungsverfahren;
Überziehen der Oberfläche des Substrates (110) mit einer Metallschicht vor dem Abscheiden des Schutzüberzuges, wobei die Metallschicht mindestens eines von Platin, Palladium, Nickel und Kobalt umfasst und
Wärmebehandeln des Substrates (110) nach dem Überziehen mit einer Metallschicht vor dem Abscheiden des Schutzüberzuges auf dem Substrat, um das Metallschicht-Material und das Substrat-Material zu verschmelzen.

2. Verfahren nach Anspruch 1, worin das Bereitstellen des Targets (108) die Bereitstellung eines Targets (108) umfasst, das 9 Atom-% Chrom, 1 Atom-% Zirkonium, Rest Aluminium aufweist.

3. Verfahren nach Anspruch 1, worin
das Substrat eine Nickelbasis-Superlegierung umfasst,
bei dem Ionenplasma-Abscheidungsverfahren während der Abscheidung des Schutzüberzuges eine Vorspannung negativen Potentials an das Substrat (110) gelegt wird;
das Substrat (110) nach dem Abscheiden des Schutzüberzuges wärmebehandelt wird und
der Schutzüberzug nach dem Wärmebehandeln eine intermetallische B2-strukturierte Aluminidphase umfasst.

4. Legierung umfassend 9 Atom-% Chrom und 1 Atom-% Zirkonium, Rest Aluminium.

5. Target (108) zum Einsatz bei einem Ionenplasma-Abscheidungsverfahren, worin das Target die Legierung nach Anspruch 4 umfasst.

6. Gegenstand zum Einsatz in einer oxidativen Umgebung hoher Temperatur, umfassend:
ein Substrat (110) und
einen über dem Substrat angeordneten Überzug, umfassend
9 Atom-% Chrom, 1 Atom-% Zirkonium wobei der Rest Aluminium ist.

## Revendications

1. Procédé de protection d'une pièce contre un milieu environnant à haute température et oxydant, lequel procédé comprend les étapes suivantes :
- prendre un substrat (110) ;
- prendre une cible (108) de dépôt par plasma d'ions, laquelle cible (108) contient du chrome en une proportion de 2 à 25 % en atomes, le reste étant constitué par de l'aluminium et, en option, jusqu'environ 4 % en atomes d'un matériau choisi parmi les zirconium, hafnium, tantale, silicium, yttrium, titane, lanthane et cérium et leurs combinaisons, et jusqu'environ 0,2 % d'un matériau choisi parmi le carbone, le bore et leurs combinaisons ;
- déposer un revêtement protecteur sur ledit substrat (110) en utilisant ladite cible (108) dans une opération de dépôt par plasma d'ions ;
- revêtir la surface du substrat (110), avant d'y déposer le revêtement protecteur, avec une couche de métal qui comporte au moins de l'un des platine, palladium, nickel et cobalt ;
- et soumettre le substrat (110), après l'avoir revêtu de la couche de métal et avant d'effectuer sur lui le dépôt par plasma d'ions du revêtement protecteur, à un traitement thermique qui provoque la fusion-interpénétration du matériau de la couche de métal et du matériau du substrat.

2. Procédé conforme à la revendication 1, dans lequel prendre ladite cible (108) consiste à prendre une cible (108) qui contient 9 % en atomes de chrome et 1 % en atomes de zirconium, le reste étant constitué par de l'aluminium.

3. Procédé conforme à la revendication 1, dans lequel :
- le substrat (110) comprend un super-alliage à base de nickel ;
- au cours de l'opération de dépôt par plasma d'ions, on applique un potentiel négatif audit substrat (110) pendant le dépôt dudit revêtement protecteur ;
- après le dépôt dudit revêtement protecteur, on soumet ledit substrat (110) à un traitement thermique ;
- et après ce traitement thermique, ledit revêtement protecteur comporte une phase intermétallique d'aluminiure à structure B2.

4. Alliage contenant 9 % en atomes de chrome et 1 % en atomes de zirconium, le reste étant constitué par de l'aluminium.

5. Cible (108) conçue pour servir dans une opération de dépôt par plasma d'ions, laquelle cible (108) est constituée d'un alliage conforme à la revendication 4.

6. Pièce conçue pour servir dans un milieu environnant à haute température et oxydant, comprenant :
- un substrat (110) ;
- et un revêtement disposé sur ce substrat, lequel revêtement contient 9 % en atomes de chrome et 1 % en atomes de zirconium, le reste étant constitué par de l'aluminium.
